# EUROPEAN PATENT SPECIFICATION

(11) **EP 3 988 950 B1**
(45) Date of publication and mention of the grant of the patent: **03.07.2024**
(21) Application number: 21203607.3
(22) Date of filing: 20.10.2021
(51) Int. Cl.: G01R 29/22, G01R 31/28

(54) **DIAGNOSTIC DEVICE, DIAGNOSTIC METHOD, AND FIELD DEVICE**
DIAGNOSEVORRICHTUNG, DIAGNOSEVERFAHREN UND FELDGERÄT
DISPOSITIF DE DIAGNOSTIC, PROCÉDÉ DE DIAGNOSTIC ET DISPOSITIF DE TERRAIN

(30) Priority: 22.10.2020 JP 2020177622
(43) Date of publication of application: 27.04.2022
(73) Proprietor: YOKOGAWA ELECTRIC CORPORATION, Musashino-shi Tokyo 180-8750 (JP)
(72) Inventor: KONDO, Sohei, Musashino-shi (JP); KAWAMOTO, Takuya, Musashino-shi (JP); YOSHIDA, Fumihiro, Musashino-shi (JP)
(74) Representative: Osha BWB

(56) References cited:
- US-A1- 2003 038 644
- US-A1- 2008 092 675
- US-A1- 2013 057 354
- US-B1- 6 208 153

## Description

### BACKGROUND

### Technical Field

The present invention generally relates to a diagnostic device, a diagnostic method, and a field device.

### Related Art

A field device, such as a vortex flow meter, is known to use a piezoelectric element that converts a physical quantity such as oscillation, pressure, or the like into voltage. In such a field device, generally, the piezoelectric element is often provided inside the field device. Therefore, there is demand for being able to diagnose whether the piezoelectric element is operating normally without taking the piezoelectric element out of the field device.

A configuration regarding a diagnosis of a piezoelectric element is described in Patent Document 1.

### Patent Document

Patent Document 1: JP 2005-526228 A (Translation of PCT Application) US 2013/057354 A1 discloses a driver circuit, a physical quantity detection apparatus, an angular velocity detection apparatus, an integrated circuit device, and an electronic instrument.

However, in the configuration according to Patent Document 1, since an alternating current signal is applied to the piezoelectric element at at least two different frequencies and the response thereof is measured, the circuit configuration is complicated and large-scale.

### SUMMARY

One or more embodiments provide a diagnostic device and a diagnostic method capable of diagnosing the health of a piezoelectric element using a simple configuration, and field device.

A diagnostic device according to the invention is provided according to claim 1.

In the diagnostic device according to one or more embodiments, the generation circuit generates as the inspection signal an alternating current signal of a frequency that does not belong to a frequency band of an electrical signal according to a physical quantity output from the piezoelectric element. Therefore, the diagnostic device analyzes the direct current signal reflecting a response of the piezoelectric element in response to the inspection signal without the inspection signal affecting the electrical signal corresponding to the physical quantity output from the piezoelectric element, and determines the health of the piezoelectric element with respect to capacitance.

In the diagnostic device according to one or more embodiments, the control part analyzes the direct current signal to calculate a capacitance value of the piezoelectric element, and compares the capacitance value to a predetermined standard value to determine whether the piezoelectric element is operating normally as the health of the piezoelectric element. Therefore, the diagnostic device is capable of easily and accurately determining whether the piezoelectric element is operating normally.

In the diagnostic device according to one or more embodiments, the control part analyzes the direct current signal to calculate a capacitance value of the piezoelectric element, and determines an anticipated failure time regarding the piezoelectric element based on the calculated capacitance value of the piezoelectric element and a previously calculated capacitance value as the health. Therefore, the diagnostic device is capable of predicting the failure of the piezoelectric element based on past data.

The diagnostic device is further provided with a storage part for storing information related to a physical quantity measured by the piezoelectric element, wherein the control part, in response to receiving an electrical signal corresponding to the physical quantity output from the piezoelectric element, makes the storage part store a measured value of the physical quantity calculated based on the electric signal, and while the health of the piezoelectric element is being determined, outputs the measured value stored in the storage part immediately before the health is determined. Therefore, even while the health of the piezoelectric element is being determined, the measured value of the physical quantity using the piezoelectric element stored in the storage part may be output to a user.

In the diagnostic device according to one or more embodiments, the control part controls at least one of the generation circuit and the conversion circuit to change the parameters related to the operation of at least one of the generation circuit and the conversion circuit while analyzing the direct current signal to determine the health of the piezoelectric element. Therefore, the diagnostic device may more accurately determine whether the piezoelectric element is operating normally.

The diagnostic device according to one or more embodiments is further provided with an electrical resistor between the generation circuit and the piezoelectric element, wherein based on a diagnostic reference voltage, an output signal of the piezoelectric element with respect to the diagnostic reference voltage, and a resistance value of the resistor when the diagnostic reference value is applied to the piezoelectric element via the resistor from the generation circuit, the control part calculates an insulation resistance value of the piezoelectric element and determines the health of the piezoelectric element based on the insulation resistance value. Therefore, it is possible to diagnose the health of the piezoelectric element regarding insulation resistance.

A field device according to some embodiments is provided with the diagnostic device and the piezoelectric element. The field device is further provided with a plurality of the piezoelectric element, wherein the diagnostic device selects one of the piezoelectric elements from among the plurality of the piezoelectric element, and diagnoses the health of the selected piezoelectric element. Therefore, the field device is capable of diagnosing the health of each piezoelectric element by using signals from the plurality of the piezoelectric element.

According to the invention, a diagnostic method according to claim 10 is also provided.

According to one or more embodiments, it is possible to diagnose the health of the piezoelectric element using a simple configuration.

### BRIEF DESCRIPTION OF THE DRAWINGS

FIG. 1 is a diagram illustrating a first exemplary configuration of a field device according to one or more embodiments.
FIG. 2 is a diagram illustrating one example of an equivalent circuit of a piezoelectric element.
FIG. 3 is a diagram illustrating an exemplary configuration of a health confirmation circuit.
FIG. 4 is a diagram illustrating a second exemplary configuration of a field device according to one or more embodiments.
FIG. 5 is a timing chart illustrating one example of measurement timing of a piezoelectric element.
FIG. 6 is a timing chart illustrating one example of timing for diagnosing the health of a piezoelectric element.
FIG. 7 is a flowchart illustrating one example of an operation of a diagnostic device according to one or more embodiments.

### DETAILED DESCRIPTION

As a comparative example, a diagnostic device for testing a piezoelectric sensor is taught in patent document 1. The diagnostic device relating to the comparative example applies an alternating current signal to a piezoelectric sensor at at least two different frequencies, and measures a response signal from the piezoelectric sensor generated in response to the applied alternating current signal. Furthermore, the diagnostic device relating to the comparative example diagnoses the state of the piezoelectric sensor as a function of the measurement output.

However, the diagnostic device relating to the comparative example must apply an alternating current signal to the piezoelectric sensor at least two different frequencies, and therefore the circuit configuration becomes complicated and large-scale.

Embodiments of the present disclosure is described below with reference to drawings. The same or corresponding portions in each drawing are given the same reference numerals. In the description of the present embodiment, descriptions are omitted or simplified as appropriate for the same or corresponding portions.

### (First Embodiment)

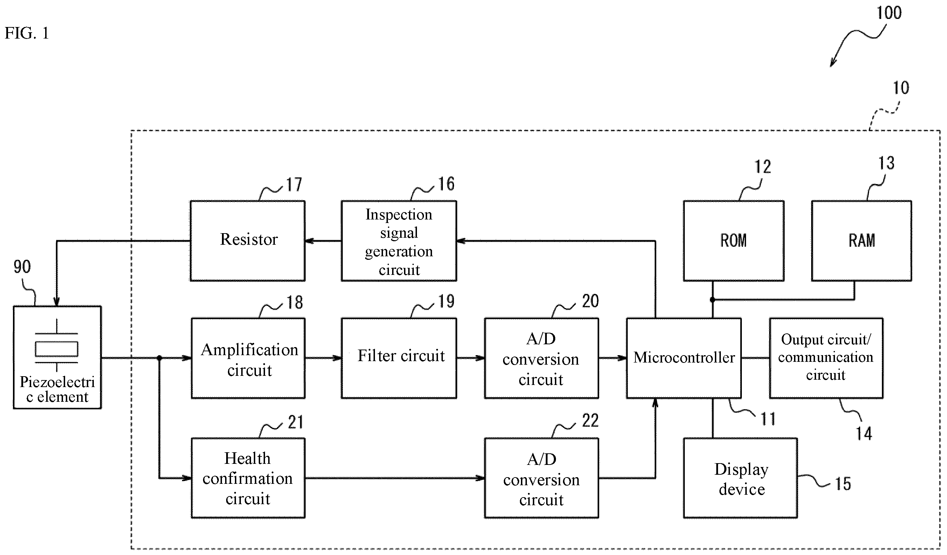

FIG. 1 is a diagram illustrating a configuration example of a field device 100 according to a first embodiment. The field device 100 is provided with a diagnostic device 10 and a piezoelectric element 90. In the field device 100, the diagnostic device 10 receives a measurement signal related to a physical quantity such as oscillation or pressure from the piezoelectric element 90, calculates a flow rate of a liquid, gas, or the like, and diagnoses whether the piezoelectric element 90 operates normally (healthy). The diagnostic device 10 is provided with a microcontroller 11 (controller), a ROM (Read Only Memory) 12, a RAM (Random Access Memory) 13, an output circuit/communication circuit 14, a display device 15, an inspection signal generation circuit 16, an electrical resistor 17, an amplification circuit 18, a filter circuit 19, an A/D (Analog-to-Digital) conversion circuit 20, a health confirmation circuit 21, and an A/D conversion circuit 22. For example, the field device 100 includes a flowmeter, a pressure gauge, or the like, provided with the piezoelectric element 90.

The microcontroller 11 as a control part controls the operation of the whole field device 100. The microcontroller 11 includes one or more processors. In one or more embodiments, a "processor" is a general-purpose processor or a dedicated processor specialized for a specific processing, but is not limited to such.

The ROM 12 is read-only memory, and stores system programs, data, and the like required for controlling the field device 100. The RAM 13 is writable memory and can function as a main storage device, an auxiliary storage device, or a cache memory. The RAM 13 may store various information such as system programs, application programs, and measurement data measured by the piezoelectric element. The ROM 12 and the RAM 13 function as a storage part for storing information relating to the physical quantities measured by the piezoelectric element 90.

The output circuit/communication circuit 14 includes any communication module capable of communication-connecting with other devices such as a PC (personal computer) by any communication technology. The output circuit/communication circuit 14 may further include a communication control module for controlling communication with other devices and a storage module for storing communication data required for communication with other devices.

The display device 15 as a display part displays information to a user. The display device 15 displays, for example, information indicating physical quantities measured by the piezoelectric element 90, health of the piezoelectric element 90, and the like. The display device 15 is realized by, for example, a liquid crystal display (LCD: Liquid Crystal Display), a meter, or the like.

When the piezoelectric element 90 is used as a sensor for the field device 100, the electrical signal generated from the piezoelectric element 90 is generally output as an electric signal belonging to a specific frequency band corresponding to the measurement target. The field device 100 according to one or more embodiments inputs an electrical signal output from the piezoelectric element 90 to the microcontroller 11 through the amplification circuit 18, the filter circuit 19, and the A/D conversion circuit 20, and converts the electrical signal into a physical quantity corresponding to the electrical signal in the microcontroller 11.

The amplification circuit 18 amplifies the amplitude of the electrical signal output from the piezoelectric element 90. The electrical signal whose amplitude is amplified is output to the filter circuit 19.

The filter circuit 19 passes only the electrical signal of a predetermined frequency band from among the electrical signals output from the amplification circuit 18, and performs filtering processing for attenuating the electrical signals belonging to other frequency bands. The filter circuit 19 is realized by an LPF (Low-Pass Filter), an HPF (High-Pass Filter), a BPF (Band-Pass Filter), a BEF (Band-Elimination Filter) or a combination thereof. An electrical signal subjected to filtering processing is output to the A/D conversion circuit 20.

The A/D conversion circuit 20 converts an electrical signal input as an analog signal into a digital signal. The electrical signal converted into a digital signal is output to the microcontroller 11.

The microcontroller 11 converts the digital electrical signal input from the A/D conversion circuit 20 into a physical quantity corresponding to the electrical signal. For example, when the piezoelectric element 90 is used in a vortex flow meter, the microcontroller 11 converts the input electrical signal into a movement amount (flow rate or flow velocity) of the fluid per unit time. The conversion from the electrical signal to the physical quantity is performed in accordance with the control of the program stored in the ROM 12 or the RAM 13 in advance. The microcontroller 11 displays the physical quantity acquired by the conversion on the display device 15 so that the user can confirm it. Alternatively, the microcontroller 11 may output the acquired physical quantity to another device using the output circuit/communication circuit 14, so that the user can confirm the physical quantity.

Meanwhile, when diagnosing whether the piezoelectric element 90 operates normally, the microcontroller 11 generates an inspection signal of a single frequency, which is a pulse wave from the inspection signal generation circuit 16, and inputs the inspection signal to the piezoelectric element 90 via the electrical resistor 17. The response signal of the piezoelectric element 90 to the inspection signal is input to the microcontroller 11 via the health confirmation circuit 21 and the A/D conversion circuit 22. The microcontroller 11 determines whether the piezoelectric element 90 operates normally based on the response signal which is a transient response of the piezoelectric element 90 to the inspection signal.

The inspection signal generation circuit 16 as a generation circuit generates an inspection signal of a single frequency for inspecting whether the piezoelectric element 90 operates normally based on the control of the microcontroller 11. The inspection signal is, for example, an alternating current signal of a frequency not belonging to the frequency band of the electrical signal according to the measured value of the physical quantity output from the piezoelectric element 90. The inspection signal may be, for example, an alternating current signal of a frequency sufficiently separated from the frequency band of the electrical signal corresponding to the measured value of the physical quantity. When the field device 100 is used, for example, as a vortex flow meter for measuring the flow rate of the fluid moving within the piping, the frequency of the inspection signal can be set to the same value (for example, 12.8kHz) regardless of the thickness (inner diameter, etc.) of the piping. The inspection signal generated in the inspection signal generation circuit 16 is output to the electrical resistor 17.

The electrical resistor 17 is a resistor whose resistance value is known in advance. The electrical resistor 17 may have, for example, a high resistance of 10 MΩ. The inspection signal output from the inspection signal generation circuit 16 to the electrical resistor 17 is output to the piezoelectric element 90 after passing through the electrical resistor 17.

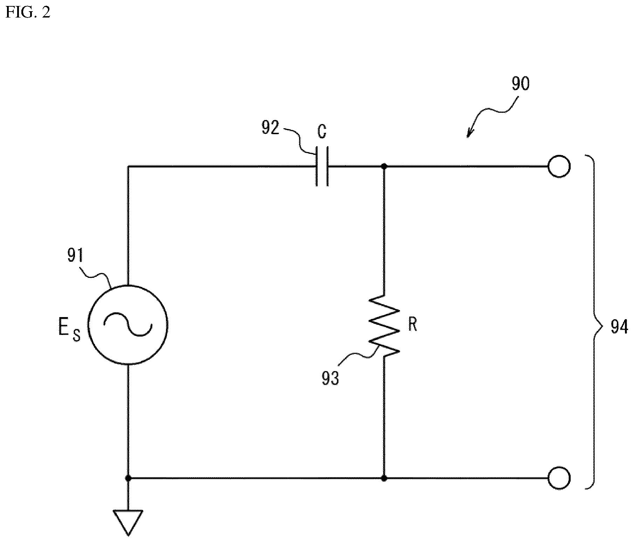

The piezoelectric element 90 is an element for generating an electrical signal according to mechanical motion such as oscillation and pressure. FIG. 2 is a diagram illustrating one example of an equivalent circuit of the piezoelectric element 90. As illustrated in FIG. 2, the piezoelectric element 90 can be modeled as an insulation resistor R93, a capacitance C92 connected in parallel with the insulation resistor R93, and a voltage source ES91. When the piezoelectric element 90 operates normally, the insulation resistor R93 is, for example, 50 kΩ and the capacitance C92 is, for example, 30 pF or less. When an inspection signal is input to the piezoelectric element 90, the response signal of the piezoelectric element 90 to the inspection signal is output to the health confirmation circuit 21 as a voltage between terminals 94 or a current flowing between terminals 94.

The response signal of the piezoelectric element 90 to the inspection signal is also output to the amplification circuit 18, but as mentioned above, the frequency of the inspection signal does not belong to the frequency band of the electrical signal corresponding to the measured value of the physical quantity output from the piezoelectric element 90. Therefore, the response signal of the piezoelectric element 90 to the inspection signal output to the amplification circuit 18 is removed by the filter circuit 19.

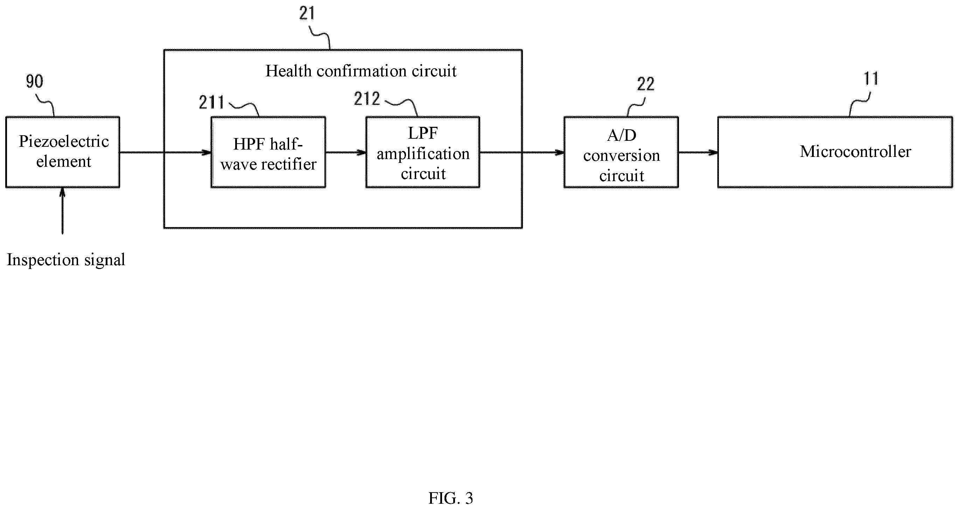

The health confirmation circuit 21 as a conversion circuit converts the response signal of the piezoelectric element 90 into a direct current signal reflecting the resistance value of the insulation resistor R93 and the capacitance value of the capacitance C92. FIG. 3 is a diagram illustrating a configuration example of the health confirmation circuit 21. The health confirmation circuit 21 is provided with an HPF half-wave rectifier 211 and an LPF amplification circuit 212.

The HPF half-wave rectifier 211 extracts a component of a frequency of a predetermined threshold or more from a response signal of the piezoelectric element 90 to an inspection signal. Further, the HPF half-wave rectifier 211 performs half-wave rectification of the high frequency component of the response signal. The HPF half-wave rectifier 211 can be realized by, for example, an operational amplifier. The response signal subjected to these processes is output to the LPF amplification circuit 212.

The LPF amplification circuit 212 extracts a component of a frequency of less than a predetermined threshold from a response signal input from the HPF half-wave rectifier 211. Further, the LPF amplification circuit 212 amplifies the amplitude of the low frequency component of the response signal. The processing of the HPF half-wave rectifier 211 and the LPF amplification circuit 212 is equivalent to converting a response signal that is an alternating current signal into a direct current signal. The response signal subjected to these processes is output to the A/D conversion circuit 22.

The A/D conversion circuit 22 converts the response signal input as an analog signal into a digital signal. The response signal converted into a digital signal is output to the microcontroller 11.

The microcontroller 11 acquires an output voltage from the piezoelectric element 90 when a diagnostic reference voltage is applied from the inspection signal generation circuit 16 via the electrical resistor 17, via the amplification circuit 18, the filter circuit 19, and the A/D conversion circuit 20. The diagnostic reference voltage is a voltage between the output terminal of the inspection signal generation circuit 16 and the grounded terminal of the piezoelectric element 90, and can be set as a direct current voltage. The output voltage of the piezoelectric element 90 is a voltage that voltage divides a diagnostic reference voltage by the insulation resistor R93 of the piezoelectric element 90 and the resistance of the electrical resistor 17. Therefore, the microcontroller 11 can calculate the resistance value of the insulation resistor R93 of the piezoelectric element 90 from the output voltage of the piezoelectric element 90, the known diagnostic reference voltage, and the known resistance value of the electrical resistor 17. The insulation resistor R93 has, normally, for example, a resistance value of approximately several MS2 which is a fraction of the resistance value (for example, 10 MΩ) of the electrical resistor 17. The insulation resistor R93 has, abnormally, for example, a resistance value of several dozen kΩ or less. Therefore, in this case, the output voltage shows a numerical value of a fraction of the diagnostic reference voltage normally, but shows a numerical value extremely close to 0 V abnormally.

Furthermore, the microcontroller 11 applies a pulse signal which is an alternating current signal to the piezoelectric element 90, and analyzes the response signal converted into a direct current signal reflecting the capacitance value of the capacitance C92 in the health confirmation circuit 21. The impedance of the capacitance is 1/(2πf×C) when the frequency of the inspection signal which is the pulse wave is f and the capacitance value of the capacitance C92 is C. Then, based on such a relation, the microcontroller 11 calculates the capacitance value of the capacitance C92 from the voltage value of the inspection signal and the voltage value of the response signal of the piezoelectric element 90 to the inspection signal.

The microcontroller 11 performs a good-or-bad health determination of whether the piezoelectric element 90 operates normally based on at least one value of the resistance value of the insulation resistor R93 and the capacitance value of the capacitance C92 obtained by analyzing the response signal. Specifically, the microcontroller 11, for example, compares a numerical value (for example insulation resistance 50 kQ, capacitance value 30 pF) preset as a resistance value of the insulation resistor R93 and capacitance value of the capacitance C92 with a value calculated by analyzing the response signal. Then, the microcontroller 11 may determine that the piezoelectric element 90 is faulty when the difference between the values of both exceeds a predetermined value, and may determine that the piezoelectric element 90 operates normally when the difference between the values of both is within the predetermined value. For example, the microcontroller 11 can determine that the piezoelectric element 90 is in faulty when the resistance value calculated based on the response signal is below a preset standard value or when the capacitance value calculated based on the response signal is above a preset standard value.

Alternatively, the microcontroller 11, for example, may compare a value of at least one of the resistance value of the insulation resistor R93 and the capacitance value of the capacitance C92 obtained by previous measurement with a value calculated by analyzing the response signal. In this case, the microcontroller 11, for example, may determine that the piezoelectric element 90 is faulty when the difference between the resistance value or capacitance value calculated based on the response signal and the value measured previously is above a predetermined standard value.

Alternatively, the microcontroller 11, for example, may store a value of at least one of the resistance value of the insulation resistor R93 and the capacitance value of the capacitance C92 obtained by previous measurement in the ROM 12 or the RAM 13. Then, the microcontroller 11, for example, may determine that the piezoelectric element 90 is faulty when the resistance value or capacitance value calculated based on the response signal does not conform with a change trend stored in the ROM 12 or the RAM 13. Further, the microcontroller 11 may predict the time when the piezoelectric element 90 will fail based on the resistance value or capacitance value calculated based on the response signal and trend data (the resistance value or capacitance value calculated in the past). Specifically, for example, the microcontroller 11 may predict a failure time by estimating the change of the resistance value or the capacitance value based on the slope of a graph showing the change of the resistance value or capacitance value calculated in the past for one piezoelectric element 90. Alternatively, for example, the microcontroller 11 may predict a failure time by estimating the change of the resistance value or the capacitance value based on an average of change or the slope of a graph of the resistance value or capacitance value calculated in the past for a plurality of the piezoelectric element 90. Further, the microcontroller 11 may, for example, machine-learn the insulation resistance and capacitance of the piezoelectric element 90, the use state of the piezoelectric element 90, and information on failure, or the like, as training data when the field device 100 is used as a vortex flow meter. The microcontroller 11 may generate and utilize a prediction model for predicting the failure time of the piezoelectric element 90 by such machine learning.

After performing a good-or-bad health determination of the piezoelectric element 90, the microcontroller 11 outputs the result to the outside via the display device 15 or the output circuit/communication circuit 14. The user can recognize whether the piezoelectric element 90 operates normally by confirming the result of the good-or-bad health determination. The user can also perform predictive diagnosis or the like of whether the piezoelectric element 90 will fail and need to be replaced from a change in the insulation resistance or the capacitance.

Note that a part or all of the functions of the diagnostic device 10 can be realized by executing a program according to one or more embodiments using a processor included in the microcontroller 11. That is, a part or all functions of the diagnostic device 10 can be realized by software. The program makes the computer execute the processing of the steps included in the operation of the diagnostic device 10, so that the computer can realize a function corresponding to the processing of each step. That is, the program is for making the computer function as the diagnostic device 10 according to one or more embodiments.

As described above, in the diagnostic device 10, the inspection signal generation circuit 16 generates an inspection signal, which is an alternating current signal of a single frequency. The health confirmation circuit 21 converts the response signal of the piezoelectric element 90 to the inspection signal into a direct current signal. Specifically, the health confirmation circuit 21 converts the response signal into a direct current signal by the HPF half-wave rectifier 211. The microcontroller 11 analyzes the direct current signal to determine the health of the piezoelectric element 90. Concretely, the microcontroller 11 calculates the current flowing through the piezoelectric element 90 and the voltage between terminals based on the voltage value and the current value in the electrical resistor 17, and calculates the insulation resistance value of the piezoelectric element 90. Furthermore, the microcontroller 11 analyzes the direct current signal to calculate the capacitance value of the piezoelectric element 90. Further, the microcontroller 11 compares the calculated value with a predetermined standard value to determine whether the piezoelectric element 90 operates normally as the health of the piezoelectric element 90. Therefore, the diagnostic device 10 can simply and accurately confirm the health of the piezoelectric element 90 with a simpler circuit configuration by applying an inspection signal which is a single alternating current signal.

Furthermore, the microcontroller 11 may calculate at least one of the insulation resistance value or the capacitance value of the piezoelectric element 90, and determine the health of the piezoelectric element 90 based on that value and the previously calculated past insulation resistance value and capacitance value. Thus, the microcontroller 11 can determine the failure time predicted for the piezoelectric element 90 as health.

Furthermore, the inspection signal generation circuit 16 generates as the inspection signal an alternating current signal of a frequency that does not belong to a frequency band of an electrical signal according to the physical quantity output from the piezoelectric element 90. Therefore, the diagnostic device 10 can analyze the response signal, which is a direct current signal reflecting a signal indicating the capacitance value of the capacitance C92, without the inspection signal affecting the measured signal output from the piezoelectric element 90, and determine the health of the piezoelectric element 90 with respect to the capacitance C92. Accordingly, the scale increase and decrease in responsiveness of the circuit configuration due to the plurality of operation modes, as well as the necessity of special operations and procedures is suppressed, and the usability to the user is remarkably improved.

### (Second Embodiment)

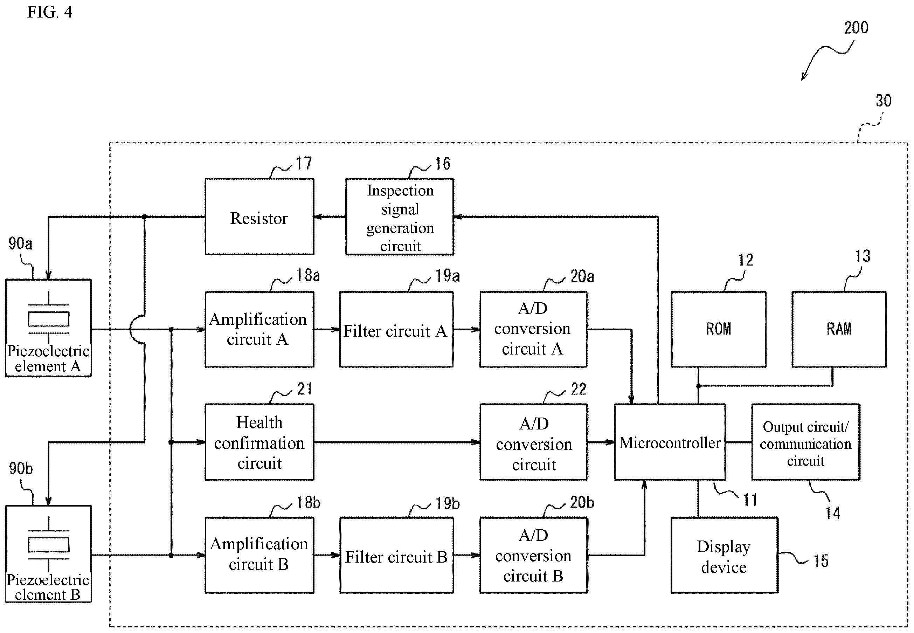

The field device 100 illustrated in FIG.1 is provided with one piezoelectric element 90, but field device provided with a plurality of piezoelectric elements 90 may be provided. FIG. 4 is a diagram illustrating a configuration example of a field device 200 according to a second embodiment. The field device is provided with two piezoelectric elements A90a, and B90b, and a diagnostic device 30. The functions and constituent elements for operation similar to the configuration in FIG. 1 are given the same reference numerals, and detailed descriptions thereof are omitted.

The diagnostic device 30 is provided with the microcontroller 11, the ROM 12, the RAM 13, the output circuit/communication circuit 14, a display device 15, the inspection signal generation circuit 16, the electrical resistor 17, an amplification circuit A18a, an amplification circuit B18b, a filter circuit A19a, a filter circuit B19b, an A/D conversion circuit A20a, an A/D conversion circuit B20b, the health confirmation circuit 21, and the A/D conversion circuit 22.

An electrical signal output from the piezoelectric element A90a is input to the microcontroller 11 through the amplification circuit A18a, the filter circuit A19a, and the A/D conversion circuit A20a, and is converted into a physical quantity corresponding to the electrical signal in the microcontroller 11. An electrical signal output from the piezoelectric element B90b is input to the microcontroller 11 through the amplification circuit B 18b, the filter circuit B 19b, and the A/D conversion circuit B20b, and is converted into a physical quantity corresponding to the electrical signal in the microcontroller 11. The operations of the amplification circuit A18a, the amplification circuit B18b, the filter circuit A19a, the filter circuit B19b, the A/D conversion circuit A20a, and the A/D conversion circuit B20b are similar to the amplification circuit 18, the filter circuit 19, and the A/D conversion circuit 20. Thus, in a configuration that measures a physical quantity more accurately by providing a plurality of piezoelectric elements (piezoelectric element A90a and piezoelectric element B90b), the field device 200 can diagnose the health of each piezoelectric element by using a response signal to an inspection signal from the plurality of piezoelectric elements.

Furthermore, when diagnosing whether the piezoelectric element A90a and the piezoelectric element B90b are operating normally, the field device 200 generates an inspection signal in the inspection signal generation circuit 16 similarly to the field device 100. The field device 200 outputs the generated inspection signal to the piezoelectric element A90a and the piezoelectric element B90b via the electrical resistor 17. When the inspection signal is output to the piezoelectric element A90a and the piezoelectric element B90b, it is necessary to distinguish the response signal from the piezoelectric element A90a from the response signal from the piezoelectric element B90b. Therefore, a switch is provided between the electrical resistor 17 and the piezoelectric element A90a and the piezoelectric element B90b, and the microcontroller 11 may apply an inspection signal to one piezoelectric element by switching the switch in conjunction with the output of the inspection signal from the inspection signal generation circuit 16. Alternatively, the microcontroller 11 may control the inspection signal generation circuit 16, select a piezoelectric element 90 to be an output destination of the inspection signal, and control the inspection signal generation circuit 16 so as to output the inspection signal to the selected piezoelectric element 90. Alternatively, the microcontroller 11 may control the inspection signal generation circuit 16 to shift the timing of the output to the piezoelectric element A90a and the output to the piezoelectric element B90b. The health confirmation circuit 21 converts a response signal to the inspection signal from the piezoelectric element A90a or the piezoelectric element B90b into a direct current signal and outputs it to the microcontroller 11 via the A/D conversion circuit 22. The microcontroller 11, similarly to the field device 100, diagnoses whether the piezoelectric element A90a and the piezoelectric element B90b operate normally based on the response signal. Accordingly, according to the configuration of FIG. 4, even in a field device 200 provided with a plurality of piezoelectric elements 90a and 90b, it is determined whether each of the piezoelectric elements 90a and 90b operate normally.

### (Third Embodiment)

The diagnostic device 10 cannot diagnose the health relating to the capacitance value of the capacitance C92 of the piezoelectric element 90 at the same time that the piezoelectric element 90 outputs a measurement signal. Therefore, the microcontroller 11 must control each constituent element so that the timing of determining the health regarding the capacitance value of the capacitance C92 of the piezoelectric element 90 is different from the timing of the piezoelectric element 90 measuring the physical quantity. However, when the diagnostic device 10 is used for the field device 100 such as a vortex flow meter, the measurement of the physical quantity and the display thereof are not required to have high responsiveness, and it is generally not a problem from the viewpoint of the user even if a delay of several seconds occurs between the measurement and the display. Thus, in the third embodiment, the microcontroller 11, immediately before switching from a measuring mode for measuring the physical quantity to a diagnostic mode for determining the health relating to the capacitance value of the piezoelectric element 90, saves to the RAM 13 the physical quantity measured by the measurement mode immediately before switching. Furthermore, the microcontroller 11 continuously outputs the physical quantity stored in the RAM 13, and displays the physical quantity on the display device 15 even in the diagnostic mode. Therefore, even if the measured value of the physical quantity fluctuates due to the diagnosis of health, the diagnostic device 10 in the third embodiment can show such that the diagnosis relating to the measurement of the physical quantity and the capacitance value of the piezoelectric element 90 can be performed at the same time without displaying the fluctuation to the user.

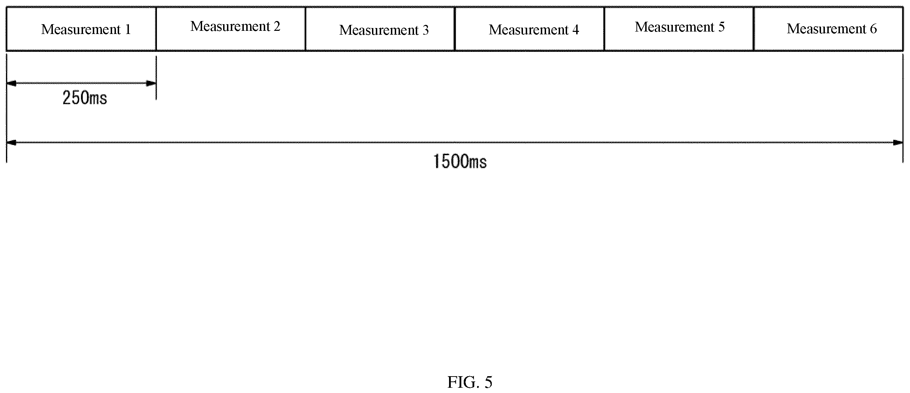

FIG. 5 is a timing chart illustrating one example of measurement timing of the piezoelectric element 90. In the example of FIG. 5, the physical quantity is measured by the piezoelectric element 90 six times in a cycle of 250 ms. The microcontroller 11 stores the measured value of the physical quantity measured by the measurement mode in each measurement mode (measurement 1 to measurement 6) in the RAM 13. Moreover, the microcontroller 11 displays the latest measured value of the physical quantity on the display device 15. Thus, the user can confirm the latest measured value of the physical quantity. In the third embodiment, the microcontroller 11 controls the inspection signal generation circuit 16 so as not to generate an inspection signal during a measurement mode in which the physical quantity is measured by the piezoelectric element 90.

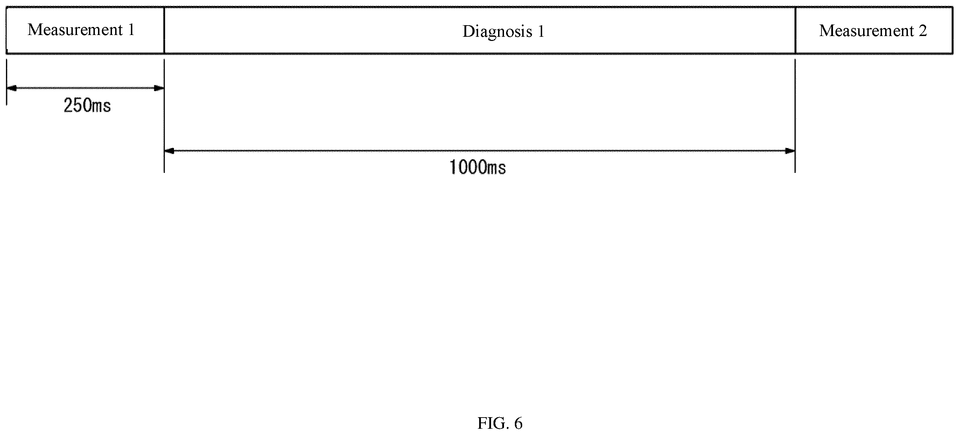

FIG. 6 is a timing chart illustrating one example of timing for diagnosing the health of the piezoelectric element 90. In the example shown in FIG. 6, after the measurement mode shown in measurement 1, the health of the piezoelectric element 90 is diagnosed based on the response of the inspection signal in a diagnostic mode (diagnosis 1) of 1000 ms (1 second). In the third embodiment, the physical quantity measured in the measurement 1 is stored in the RAM 13 during the measurement 1 period. Thus, the microcontroller 11 continuously displays the measured value of the physical quantity in the measured value 1 on the display device 15 even during the period of the diagnostic mode of the diagnosis 1. That is, while the health of the piezoelectric element 90 is being determined, the microcontroller 11 outputs the measured value of the physical quantity stored in the RAM 13 immediately before the health determination and displays it on the display device 15. Therefore, even while the health of the piezoelectric element is being determined, the measured value of the physical quantity stored in the RAM 13 can be output and displayed.

### (Fourth Embodiment)

In a fourth embodiment, when the health of the piezoelectric element 90 is diagnosed in a diagnostic mode, the diagnostic device 10 more easily detects a failure of the piezoelectric element 90 by observing a response signal from the piezoelectric element 90 while varying parameters related to at least one operation of the inspection signal generation circuit 16 and the health confirmation circuit 21. As specific parameters to be varied, at least one of the frequency and voltage of the inspection signal generation circuit 16 and a constant of the health confirmation circuit 21 are considered.

That is, the microcontroller 11 may make at least one of the frequency and the amplitude of the inspection signal generation circuit 16 variable a parameter related to the operation of the inspection signal generation circuit 16 during diagnosis. The response signal from the piezoelectric element 90 to the inspection signal generally shows expected behavior, but shows unexpected behavior in abnormal situations, such as when a failure occurs in the piezoelectric element 90 or the like. Therefore, the microcontroller 11 can easily detect such abnormalities in the piezoelectric element 90 by changing the frequency and amplitude. The microcontroller 11, for example, stores the normal behavior when the frequency and the amplitude are varied in the ROM 12 or the RAM 13, and compares it with the response signal from the piezoelectric element 90. Since different behavior is shown in abnormal situations, the microcontroller 11 can detect abnormalities based on when there is a difference in the behavior of the response. Moreover, as parameters related to the operation of the inspection signal generation circuit 16, for example, the value of the power supply voltage of the inspection signal generation circuit 16 and the like can also be considered.

Alternatively, the microcontroller 11 may, during diagnosis, vary the constant of the health confirmation circuit 21 as a parameter related to the operation of the health confirmation circuit 21, and confirm the health of the piezoelectric element 90 based on the behavior of the change of the response signal of the piezoelectric element 90 according to the change of the constant. The microcontroller 11 can change the waveform of the output of the HPF half-wave rectifier 211 by changing the feedback rate of the operational amplifier of the HPF half-wave rectifier 211 as a constant of the health confirmation circuit 21. For example, the microcontroller 11 can vary the feedback rate of the operational amplifier so that a direct current voltage (for example, a positive direct current voltage) is output from the health confirmation circuit 21 when the piezoelectric element 90 operates normally, but is not output (for example, zero volts) when it is abnormal. Therefore, the microcontroller 11 can more easily detect the abnormality of the piezoelectric element 90 by changing the feedback rate of the operational amplifier. Moreover, as parameters related to the operation of the health confirmation circuit 21, for example, the value of the power supply voltage of the health confirmation circuit 21 and the like can also be considered.

### <Operation Example>

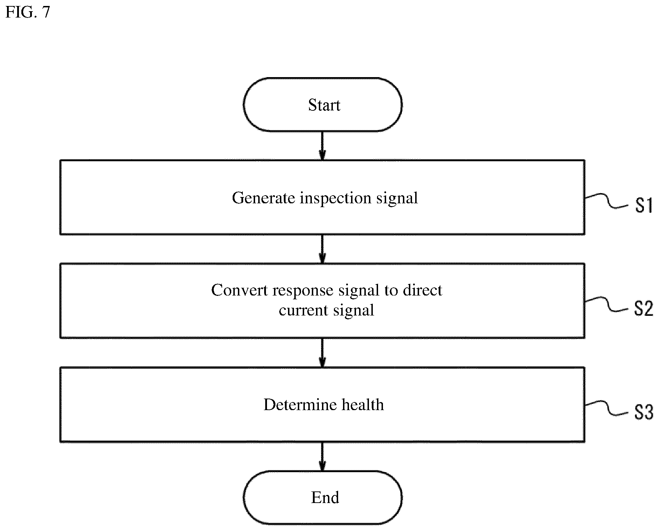

The operation of the diagnostic device 10 according to one or more embodiments is described with reference to FIG. 7. FIG. 7 is a flowchart illustrating one example of an operation of the diagnostic device 10 according to one or more embodiments. The operation of the diagnostic device 10 described with reference to FIG. 7 corresponds to the diagnostic method relating to the present embodiment. The operation of each step in FIG. 7 is executed based on the control of the microcontroller 11 as a control part. A program for making a computer execute a diagnostic method relating to the present embodiment includes steps shown in FIG. 7.

In step S1, the microcontroller 11 controls the inspection signal generation circuit 16 to generate an inspection signal. The inspection signal is output to the piezoelectric element 90 via the electrical resistor 17.

In step S2, the microcontroller 11 makes the health confirmation circuit 21 receive the response signal of the piezoelectric element 90. Further, the health confirmation circuit 21 converts the response signal of the piezoelectric element 90 to the inspection signal into a direct current signal. The response signal converted into a direct current signal is output to the microcontroller 11 via the A/D conversion circuit 22.

In step S3, the microcontroller 11 analyzes the direct current signal to determine the health of the piezoelectric element 90. The details of each step are as described above.

Therefore, the diagnostic device 10 is capable of diagnosing the health of the piezoelectric element 90 using a simple configuration.

Although the disclosure has been described with respect to only a limited number of embodiments, those skilled in the art, having benefit of this disclosure, will appreciate that various other embodiments may be devised without departing from the scope of the present invention. Accordingly, the scope of the invention should be limited only by the attached claims.

- 10, 30: Diagnostic device
- 11: Microcontroller
- 12: ROM
- 13: RAM
- 14: Output circuit/communication circuit
- 15: Display device
- 16: Inspection signal generation circuit
- 17: Electrical resistor
- 18, 18a, 18b: Amplification circuit
- 19, 19a, 19b: Filter circuit
- 20, 20a, 20b: A/D conversion circuit
- 21: Health confirmation circuit
- 22: A/D conversion circuit
- 90, 90a, 90b: Piezoelectric element
- 91: Voltage source
- 92: Capacitance
- 93: Insulation resistor
- 94: Between terminals
- 100, 200: Field device
- 211: HPF half-wave rectifier
- 212: LPF amplification circuit

## Claims

1. A diagnostic device (10) comprising:
a generation circuit (16) configured to generate an inspection signal, the inspection signal being an alternating current signal of a single frequency,
a conversion circuit (21) configured to convert, into a direct current signal, a response signal of a piezoelectric element (90) in response to the inspection signal,
a storage configured to store information related to a physical quantity measured by the piezoelectric element (90), and
a controller (11) configured to:
analyze the direct current signal;
in response to receiving an electrical signal corresponding to a physical quantity output from the piezoelectric element (90), cause the storage to store a measured value of the physical quantity calculated based on the electrical signal;
determine, based on the analysis of the direct current signal, whether the piezoelectric element (90) is operating normally, and
while it is being determined whether the piezoelectric element (90) is operating normally, outputs the measured value that is stored in the storage immediately before it is being determined whether the piezoelectric element (90) is operating normally.

2. The diagnostic device (10) according to claim 1, wherein the conversion circuit (21) comprises a half-wave rectifier (211).

3. The diagnostic device (10) according to claim 1 or claim 2, wherein the inspection signal is an alternating current signal of which the frequency does not belong to a frequency band of an electrical signal according to a physical quantity output from the piezoelectric element (90).

4. The diagnostic device (10) according to any one of the preceding claims, wherein the controller (11) is further configured to:
analyze the direct current signal to calculate a capacitance value of the piezoelectric element (90);
compare the capacitance value to a predetermined standard value; and
determine, based on a result of the comparison, whether the piezoelectric element (90) is operating normally.

5. The diagnostic device (10) according to any one of claims 1-3, wherein the controller (11) is further configured to:
analyze the direct current signal to calculate a capacitance value of the piezoelectric element (90); and
determine, based on the calculated capacitance value and a previously calculated capacitance value, an anticipated failure time regarding the piezoelectric element (90).

6. The diagnostic device (10) according to any one of the preceding claims, wherein the controller (11) is further configured to:
control an operation of at least one of the generation circuit (16) or the conversion circuit (21);
change parameters related to the operation while analyzing the direct current signal; and
determine, based on the changed parameters, whether the piezoelectric element (90) is operating normally.

7. The diagnostic device (10) according to any one of the preceding claims, further comprising:
an electrical resistor (17) between the generation circuit (16) and the piezoelectric element (90), wherein
the controller (11) is configured to:
calculate, based on a diagnostic reference voltage, an output signal of the piezoelectric element (90) with respect to the diagnostic reference voltage, and a resistance value of the resistor (17) when the diagnostic reference value is applied to the piezoelectric element (90) via the resistor (17) from the generation circuit (16), an insulation resistance value of the piezoelectric element (90); and
determine, based on the insulation resistance value, whether the piezoelectric element (90) is operating normally.

8. A field device (100), comprising:
the diagnostic device (10) according to any of the preceding claims; and
the piezoelectric element (90).

9. The field device (100) according to claim 8, further comprising one or more piezoelectric elements (90a, 90b), wherein
the diagnostic device (10) is configured to:
select, from the piezoelectric elements (90a, 90b), a first piezoelectric element (90a); and
determine whether the first piezoelectric element (90a) is operating normally.

10. A diagnostic method, comprising:
generating (S1), with a generation circuit, an inspection signal, the inspection signal being an alternating current signal of a single frequency;
converting (S2), with a conversion circuit (21), a response signal of a piezoelectric element (90) in response to the inspection signal into a direct current signal,
in response to receiving an electrical signal corresponding to a physical quantity output from the piezoelectric element (90), storing, with a controller (11), in a storage a measured value of the physical quantity calculated based on the electrical signal;
analyzing (S3), with the
controller (11), the direct current signal to determine whether the piezoelectric element (90) is operating normally; and
while it is being determined whether the piezoelectric element (90) is operating normally, output, with the controller,
the measured value that is stored in the storage immediately before the determination of whether the piezoelectric element (90) is operating normally.

## Patentansprüche

1. Eine Diagnosevorrichtung (10), aufweisend:
eine Erzeugerschaltung (16), die konfiguriert ist, um ein Inspektionssignal zu erzeugen, wobei das Inspektionssignal ein Wechselstromsignal mit einer einzigen Frequenz ist,
eine Umwandlungsschaltung (21), die konfiguriert ist, um ein Reaktionssignal eines piezoelektrischen Elements (90) als Reaktion auf das Inspektionssignal in ein Gleichstromsignal umzuwandeln,
einen Speicher, der konfiguriert ist, um Informationen zu speichern, die sich auf eine von dem piezoelektrischen Element (90) gemessene physikalische Größe beziehen, und
eine Steuereinheit (11), die konfiguriert ist, um:
das Gleichstromsignal zu analysieren;
als Reaktion auf den Empfang eines elektrischen Signals, das einer physikalischen Ausgangsgröße des piezoelektrischen Elements (90) entspricht, den Speicher zu veranlassen, einen Messwert der physikalischen Größe zu speichern, der auf der Grundlage des elektrischen Signals berechnet wird;
auf der Grundlage der Analyse des Gleichstromsignals zu bestimmen, ob das piezoelektrische Element (90) normal betrieben wird, und
während der Bestimmung, ob das piezoelektrische Element (90) normal betrieben wird, den Messwert auszugeben, der in dem Speicher gespeichert ist, unmittelbar bevor bestimmt wird, ob das piezoelektrische Element (90) normal betrieben wird.

2. Die Diagnosevorrichtung (10) nach Anspruch 1, wobei die Umwandlungsschaltung (21) einen Einweggleichrichter (211) aufweist.

3. Die Diagnosevorrichtung (10) nach Anspruch 1 oder Anspruch 2, wobei das Inspektionssignal ein Wechselstromsignal ist, von dem die Frequenz nicht zu einem Frequenzband eines elektrischen Signals gemäß einer physikalischen Ausgangsgröße des piezoelektrischen Elements (90) gehört.

4. Die Diagnosevorrichtung (10) nach einem der vorhergehenden Ansprüche, wobei die Steuereinheit (11) ferner konfiguriert ist, um:
das Gleichstromsignal zu analysieren, um einen Kapazitätswert des piezoelektrischen Elements (90) zu berechnen;
den Kapazitätswert mit einem vorbestimmten Standardwert zu vergleichen; und
auf der Grundlage eines Ergebnisses des Vergleichs zu bestimmen, ob das piezoelektrische Element (90) normal betrieben wird.

5. Die Diagnosevorrichtung (10) nach einem der Ansprüche 1 bis 3, wobei die Steuereinheit (11) ferner konfiguriert ist, um:
das Gleichstromsignal zu analysieren, um einen Kapazitätswert des piezoelektrischen Elements (90) zu berechnen; und
auf der Grundlage des berechneten Kapazitätswerts und eines zuvor berechneten Kapazitätswerts eine voraussichtliche Ausfallzeit in Bezug auf das piezoelektrische Element (90) zu bestimmen.

6. Die Diagnosevorrichtung (10) nach einem der vorhergehenden Ansprüche, wobei die Steuereinheit (11) ferner konfiguriert ist, um:
einen Betrieb der Erzeugerschaltung (16) und/oder der Umwandlungsschaltung (21) zu steuern;
Parameter zu ändern, die sich auf den Betrieb während der Analyse des Gleichstromsignals beziehen; und
auf der Grundlage der geänderten Parameter zu bestimmen, ob das piezoelektrische Element (90) normal betrieben wird.

7. Die Diagnosevorrichtung (10) nach einem der vorhergehenden Ansprüche, die ferner aufweist:
einen elektrischen Widerstand (17) zwischen der Erzeugerschaltung (16) und dem piezoelektrischen Element (90), wobei
die Steuereinheit (11) konfiguriert ist, um:
basierend auf einer diagnostischen Referenzspannung, ein Ausgangssignal des piezoelektrischen Elements (90) in Bezug auf die diagnostische Referenzspannung und einen Widerstandswert des Widerstands (17), wenn der diagnostische Referenzwert über den Widerstand (17) von der Erzeugerschaltung (16) an das piezoelektrische Element (90) angelegt wird, einen Isolationswiderstandswert des piezoelektrischen Elements (90) zu berechnen; und
auf der Grundlage des Isolationswiderstandswertes zu bestimmen, ob das piezoelektrische Element (90) normal betrieben wird.

8. Eine Feldvorrichtung (100), aufweisend:
die Diagnosevorrichtung (10) nach einem der vorhergehenden Ansprüche; und
das piezoelektrische Element (90).

9. Die Feldvorrichtung (100) nach Anspruch 8, die ferner ein oder mehrere piezoelektrische Elemente (90a, 90b) aufweist, wobei
die Diagnosevorrichtung (10) konfiguriert ist, um:
aus den piezoelektrischen Elementen (90a, 90b) ein erstes piezoelektrisches Element (90a) auszuwählen; und
zu bestimmen, ob das erste piezoelektrische Element (90a) normal betrieben wird.

10. Ein Diagnoseverfahren, die folgenden Schritte aufweisend:
Erzeugen (S1) eines Inspektionssignals mit einer Erzeugerschaltung, wobei das Inspektionssignal ein Wechselstromsignal mit einer einzigen Frequenz ist;
Umwandeln (S2), mit einer Umwandlungsschaltung (21), eines Reaktionssignals eines piezoelektrischen Elements (90) als Reaktion auf das Inspektionssignal in ein Gleichstromsignal,
als Reaktion auf den Empfang eines elektrischen Signals, das einer physikalischen Ausgangsgröße des piezoelektrischen Elements (90) entspricht, Speichern eines Messwerts der physikalischen Größe, der auf der Grundlage des elektrischen Signals berechnet wurde, mit einer Steuereinheit (11) in einem Speicher;
Analysieren (S3) des Gleichstromsignals mit der Steuereinheit (11), um zu bestimmen, ob das piezoelektrische Element (90) normal betrieben wird; und
während der Bestimmung, ob das piezoelektrische Element (90) normal betrieben wird, den Messwert, mit der Steuereinheit, auszugeben, der in dem Speicher unmittelbar vor der Bestimmung, ob das piezoelektrische Element (90) normal betrieben wird, gespeichert ist.

## Revendications

1. Dispositif de diagnostic (10) comprenant :
un circuit de génération (16) configuré pour générer un signal d'inspection, le signal d'inspection étant un signal de courant alternatif d'une fréquence unique,
un circuit de conversion (21) configuré pour convertir, en un signal de courant continu, un signal de réponse d'un élément piézoélectrique (90) en réponse au signal d'inspection,
un stockage configuré pour stocker des informations relatives à une quantité physique mesurée par l'élément piézoélectrique (90), et
un contrôleur (11) configuré pour :
analyser le signal de courant continu ;
en réponse à la réception d'un signal électrique correspondant à une quantité physique fournie à partir de l'élément piézoélectrique (90), permettre au stockage de stocker une valeur mesurée de la quantité physique calculée sur la base du signal électrique ;
déterminer, sur la base de l'analyse du signal de courant continu, si l'élément piézoélectrique (90) fonctionne normalement ou non, et
pendant qu'il est déterminé si l'élément piézoélectrique (90) fonctionne normalement ou non, fournir la valeur mesurée qui est stockée dans le stockage immédiatement avant qu'il soit déterminé si l'élément piézoélectrique (90) fonctionne normalement ou non.

2. Dispositif de diagnostic (10) selon la revendication 1, dans lequel le circuit de conversion (21) comprend un redresseur demi-onde (211).

3. Dispositif de diagnostic (10) selon la revendication 1 ou la revendication 2, dans lequel le signal d'inspection est un signal de courant alternatif dont la fréquence n'appartient pas à une bande de fréquence d'un signal électrique fonction d'une quantité physique fournie à partir de l'élément piézoélectrique (90).

4. Dispositif de diagnostic (10) selon l'une quelconque des revendications précédentes, dans lequel le contrôleur (11) est en outre configuré pour :
analyser le signal de courant continu pour calculer une valeur de capacité de l'élément piézoélectrique (90) ;
comparer la valeur de capacité à une valeur standard prédéterminée ; et
déterminer, sur la base d'un résultat de la comparaison, si l'élément piézoélectrique (90) fonctionne normalement ou non.

5. Dispositif de diagnostic (10) selon l'une quelconque des revendications 1 à 3, dans lequel le contrôleur (11) est en outre configuré pour :
analyser le signal de courant continu pour calculer une valeur de capacité de l'élément piézoélectrique (90) ; et
déterminer, sur la base de la valeur de capacité calculée et d'une valeur de capacité calculée précédemment, un temps de défaillance anticipé concernant l'élément piézoélectrique (90).

6. Dispositif de diagnostic (10) selon l'une quelconque des revendications précédentes, dans lequel le contrôleur (11) est en outre configuré pour :
contrôler un fonctionnement d'au moins un du circuit de génération (16) ou du circuit de conversion (21) ;
modifier les paramètres liés au fonctionnement tout en analysant le signal de courant continu ; et
déterminer, sur la base des paramètres modifiés, si l'élément piézoélectrique (90) fonctionne normalement ou non.

7. Dispositif de diagnostic (10) selon l'une quelconque des revendications précédentes, comprenant en outre :
une résistance électrique (17) entre le circuit de génération (16) et l'élément piézoélectrique (90), dans lequel
le contrôleur (11) est configuré pour :
calculer, sur la base d'une tension de référence de diagnostic, d'un signal de sortie de l'élément piézoélectrique (90) par rapport à la tension de référence de diagnostic et d'une valeur de résistance de la résistance (17) lorsque la valeur de référence de diagnostic est appliquée à l'élément piézoélectrique (90) via la résistance (17) à partir du circuit de génération (16), une valeur de résistance d'isolement de l'élément piézoélectrique (90) ; et
déterminer, sur la base de la valeur de résistance d'isolement, si l'élément piézoélectrique (90) fonctionne normalement ou non.

8. Dispositif de terrain (100) comprenant :
le dispositif de diagnostic (10) selon l'une quelconque des revendications précédentes ; et
l'élément piézoélectrique (90).

9. Dispositif de terrain (100) selon la revendication 8, comprenant en outre un ou plusieurs éléments piézoélectriques (90a, 90b), dans lequel
le dispositif de diagnostic (10) est configuré pour :
sélectionner, parmi les éléments piézoélectriques (90a, 90b), un premier élément piézoélectrique (90a) ; et
déterminer si le premier élément piézoélectrique (90a) fonctionne normalement ou non.

10. Procédé de diagnostic, comprenant :
la génération (S1), avec un circuit de génération, d'un signal d'inspection, le signal d'inspection étant un signal de courant alternatif d'une fréquence unique ;
la conversion (S2), avec un circuit de conversion (21), d'un signal de réponse d'un élément piézoélectrique (90) en réponse au signal d'inspection en un signal de courant continu,
en réponse à la réception d'un signal électrique correspondant à une quantité physique fournie à partir de l'élément piézoélectrique (90), le stockage, à l'aide d'un contrôleur (11), dans un stockage, d'une valeur mesurée de la quantité physique calculée sur la base du signal électrique ;
l'analyse (S3), avec le contrôleur (11), du signal de courant continu pour déterminer si l'élément piézoélectrique (90) fonctionne normalement ou non ; et
pendant qu'il est déterminé si l'élément piézoélectrique (90) fonctionne normalement ou non, la fourniture, avec le contrôleur, de la valeur mesurée qui est stockée dans le stockage immédiatement avant la détermination de si l'élément piézoélectrique (90) fonctionne normalement ou non.
